# EUROPEAN PATENT APPLICATION

(11) **EP 4 510 197 A1**
(43) Date of publication of application: **19.02.2025**
(21) Application number: 23787412.8
(22) Date of filing: 28.02.2023
(51) Int. Cl.: H01L 31/18, H01L 21/677, B05C 5/02, B05C 13/02, B05D 3/06, B23K 1/00, B23K 3/00, B23K 3/08

(54) **BATTERY STRING WELDING MACHINE AND BATTERY STRING WELDING METHOD**

(30) Priority: 15.04.2022 CN 202210393895
(71) Applicant: Wuxi Autowell Technology Co., Ltd., Wuxi, Jiangsu 214000 (CN)
(72) Inventor: XU, Qing, Wuxi, Jiangsu 214000 (CN)
(74) Representative: Winter, Brandl - Partnerschaft mbB
(86) International application number: PCT/CN2023/078606
(87) International publication number: WO 2023/197764

(57) **Abstract**

The present disclosure relates to a cell string welding machine. The cell string welding machine comprises a adhesive application portion, a cell feeding portion, a solder ribbon feeding portion, a conveying portion, and an irradiation portion, wherein the adhesive application portion is configured for applying photosensitive adhesive dots between preset auxiliary grid lines of cells, so as to form a row of adhesive dots on surfaces of the cells; the cell feeding portion is configured for carrying the cells having the row of adhesive dots applied thereon to the conveying portion; the solder ribbon feeding portion is configured for providing a solder ribbon group to a material receiving station of the conveying portion; the conveying portion conveys the stacked solder ribbon group and cell to the irradiation portion at a welding station; and the irradiation portion is configured for irradiating the row of adhesive dots, so as to fix the solder ribbon group to the cells, the row of adhesive dots is formed on the surfaces of the cells by means of the arrangement of the adhesive application portion, the feeding and stacking of the solder ribbon group and the cells are achieved by means of the cell feeding portion and the solder ribbon feeding portion, the conveying of the cells and the solder ribbon group is achieved by means of the conveying portion, and solder ribbons are fixed to the row of adhesive dots of the cells by means of the irradiation portion, thereby completing the production of a cell string.

## Description

### Technical Field

The present disclosure relates to the field of cell production, and in particular to a cell string welding machine and a cell string welding method.

### Background Art

Conventional cell strings are all produced by using a flux to weld solder ribbons and cells together at a high temperature, specifically by first applying the flux to the cells or the solder ribbons, then stacking the solder ribbons and the cells together, and then using a high-temperature infrared welding device to heat and melt tin coatings on the surfaces of the solder ribbons and weld the solder ribbons to main grid lines of the cells, which are made of a printed silver paste.

However, in this method, increased silver paste is consumed, increasing the costs of a cell assembly, and the silver paste covers the cells, resulting in reduced light receiving area of the cells. The photovoltaic conversion efficiency of a photovoltaic assembly is thus affected.

Currently, there are cells without main grids in the market, solder ribbons are directly connected to auxiliary grid lines of cells for conduction and convergence. However, because auxiliary grid lines are very thin, solder ribbons cannot be connected to the cells by being directly welded to auxiliary grids.

In view of this, it is necessary to develop a string welding machine and a string welding method which are specifically designed to implement this type of welding processes.

### Summary

In order to achieve the above technical object, a first aspect of the present disclosure provides a cell string welding machine, which can achieve the production of a cell string without main grids by welding. The following technical solution is provided.

A cell string welding machine includes a adhesive application portion, a cell feeding portion, a solder ribbon feeding portion, a conveying portion, and an irradiation portion, wherein the adhesive application portion is configured for applying photosensitive adhesive dots between preset auxiliary grid lines of cells, so as to form at least one row of adhesive dots perpendicular to a length direction of the auxiliary grid lines of the cells on surfaces of the cells; the cell feeding portion is configured for carrying the cells having the row of adhesive dots applied thereon to a material receiving station of the conveying portion; the solder ribbon feeding portion is configured for providing a solder ribbon group to a material receiving station of the conveying portion; the cell feeding portion and the solder ribbon feeding portion stack the solder ribbon group and the cells on the material receiving station of the conveying portion according to a preset rule, such that solder ribbons of the solder ribbon group are placed to have a one-to-one correspondence with the row of adhesive dots on the cells; the conveying portion conveys the stacked solder ribbon group and cell to the irradiation portion at a welding station; and the irradiation portion is configured for irradiating the row of adhesive dots, so as to fix the solder ribbon group to the cells.

The row of adhesive dots is formed on the surfaces of the cells by means of the arrangement of the adhesive application portion, the feeding and stacking of the solder ribbon group and the cells are achieved by means of the cell feeding portion and the solder ribbon feeding portion, the conveying of the cells and the solder ribbon group is achieved by means of the conveying portion, and solder ribbons are fixed to the row of adhesive dots of the cells by means of the irradiation portion, thereby completing the production of a cell string.

Optionally, the cell string welding machine further includes a positioning and compressing portion, the positioning and compressing portions being configured for pressing the stacked solder ribbons and cells, and the positioning and compressing portion having compressing positions staggered with the positions of the photosensitive adhesive dots.

The positioning and pressing of the solder ribbons and the cells that are stacked are achieved by means of the positioning and compressing portion, so as to prevent the offset of the solder ribbons during conveyance.

Optionally, the conveying portion comprises a conveying carrier portion and a conveying drive portion, wherein a driving end of the conveying drive portion is connected to the conveying carrier portion, the conveying drive portion is configured for driving the conveying carrier portion to convey the solder ribbon group and the cells, and the conveying carrier portion is made of a light-transmitting material.

The solder ribbon group and the cells are carried by the conveying carrier portion, the conveying drive portion drives the conveying carrier portion to achieve conveying, and the row of adhesive dots on a side of each of the cells that faces the carrier portion is irradiated by means of the light-transmitting configuration of the carrier portion.

Optionally, the irradiation portion includes at least one of a first irradiation sub-portion and a second irradiation sub-portion; the first irradiation sub-portion is arranged above a conveying surface of the conveying carrier portion at the welding station, and the first irradiation sub-portion is configured for irradiating the row of adhesive dots on front surfaces of the cells; and the second irradiation sub-portion is arranged below the conveying surface of the conveying carrier portion at the welding station, and the second irradiation sub-portion is configured for irradiating the row of adhesive dots on back surfaces of the cells.

The row of adhesive dots on the cells is irradiated by means of the arrangement of the first irradiation sub-portion, and the row of adhesive dots on the back surfaces of the cells is irradiated by means of the arrangement of the second irradiation sub-portion.

Optionally, the conveying carrier portion comprises a conveying belt and a conveying bottom plate, and the conveying drive portion includes a first drive device and a set of support rollers; a driving end of the first drive device is connected to the set of support rollers, the first drive device is configured for driving the set of support rollers to rotate, the conveying belt is sleeved on the set of support rollers, and the conveying belt rotates with the set of support rollers; the conveying bottom plate is arranged below the conveying surface of the conveying belt, and the conveying bottom plate is configured for supporting the conveying belt; and the conveying belt is a light-transmitting belt, and the conveying bottom plate is a light-transmitting plate.

The cells and the solder ribbon group are received by means of the arrangement of the conveying belt, the conveying belt is supported during the conveyance by means of the arrangement of the conveying bottom plate, the conveying belt is supported and transported by means of the arrangement of the first drive device and the set of support rollers, and the transmission of the irradiation light from the irradiation portion is achieved by configuring the conveying belt as the light-transmitting belt and the conveying bottom plate as the light-transmitting plate.

Optionally, first through holes are provided in the conveying belt, negative-pressure suction holes are provided in the conveying bottom plate, and the negative-pressure suction holes in the conveying bottom plate suck the cells to the conveying belt by means of the first through holes in the conveying belt.

By providing the first through holes in the conveying belt, the negative-pressure suction holes in a suction bottom plate suck the cells to be closely attached to the conveying belt.

Optionally, the conveying carrier portion includes a bearing plate, and the conveying drive portion includes a second drive device; a driving end of the second drive device is connected to the bearing plate, and the second drive device is configured for driving the bearing plate to be moved from the material receiving station to the welding station; the bearing plate is configured for carrying the solder ribbon group and the cells; and the bearing plate is a light-transmitting plate.

The solder ribbon group and the cells are carried by the arrangement of the bearing plate, the bearing plate is moved by the provision of the drive portion and thus the solder ribbon group and the cells are conveyed, and the transmission of the irradiation light from the irradiation portion is achieved by configuring the carrier portion as the light-transmitting plate.

Optionally, the conveying portion further includes abutting devices, the bearing plate is provided with second through holes for the abutting devices to pass through; and the abutting devices are configured for abutting the solder ribbon group conveyed by the bearing plate and located below the cells against the back surfaces of the cells.

By providing the abutting devices, the solder ribbon group below the cells can be closely attached to the cells when being exposed to the irradiation of the irradiation portion, thereby improving a welding effect.

Optionally, the positioning and compressing portion includes a mounting frame and rows of pressing pins mounted on the mounting frame, the rows of pressing pins being arranged to correspond to the solder ribbon group, and each row of pressing pins being used to press a solder ribbon.

The solder ribbons are better positioned by providing the rows of pressing pins.

Another aspect of the present disclosure provides a cell string welding method, including:
applying photosensitive adhesive dots between preset auxiliary grid lines of cells, so as to form at least one row of adhesive dots perpendicular to a length direction of the auxiliary grid lines of the cells on surfaces of the cells; providing a solder ribbon group, the number of solder ribbons of the solder ribbon group being the same as the number of the rows of adhesive dots; stacking the solder ribbon group and the cells according to a preset rule such that the stacked solder ribbons of the solder ribbon group have a one-to-one correspondence with the rows of adhesive dots on the cells; and irradiating the cells and the solder ribbon group stacked together such that the solder ribbon group and the rows of adhesive dots on the cells are bonded together to form a cell string.

The row of adhesive dots on the cells are stacked with the solder ribbon group, and the solder ribbon group and the cells stacked together are irradiated to position and weld the solder ribbon group and the cells together, thus completing the production of a cell string.

Optionally, stacking the solder ribbon group and the cells according to a preset rule includes:
stacking an i^{th} cell on a rear half of an i^{th} solder ribbon group, and stacking a front half of an (i+1)^{th} solder ribbon group on the i^{th} cell, i being any natural number greater than 0.

Optionally, stacking the solder ribbon group and the cells according to a preset rule includes: the cells being interdigitated back contact cells, connecting a front half of an I^{th} solder ribbon group to a row of positive electrode adhesive dots on a back surface of an (I-1)^{th} cell, connecting a rear half of the I^{th} solder ribbon group to a row of negative electrode adhesive dots on a back surface of an I^{th} cell, and connecting a front half of an (I+1)^{th} solder ribbon group to a row of positive electrode adhesive dots on the back surface of the I^{th} cell, and connecting a rear half of the (I+1)^{th} solder ribbon group to a row of negative electrode adhesive dots on a back surface of an (I+1)^{th} cell, I being any odd number greater than 0; or connecting the front half of the I^{th} solder ribbon group to a row of negative electrode adhesive dots on the back surface of the (I-1)^{th} cell, connecting the rear half of the I^{th} solder ribbon group to a row of positive electrode adhesive dots on the back surface of the I^{th} cell, and connecting the front half of the (I+1)^{th} solder ribbon group to the row of negative electrode adhesive dots on the back surface of the I^{th} cell, and connecting the rear half of the (I+1)^{th} solder ribbon group to the row of positive electrode adhesive dots on the back surface of the (I+1)^{th} cell, I being any odd number greater than 0.

According to the cell string welding machine provided in the present disclosure, the row of adhesive dots is formed on the surfaces of the cells by means of the arrangement of the adhesive application portion, the feeding and stacking of the solder ribbon group and the cells are achieved by means of the cell feeding portion and the solder ribbon feeding portion, the conveying of the cells and the solder ribbon group is achieved by means of the conveying portion, and solder ribbons are fixed to the row of adhesive dots of the cells by means of the irradiation portion, thereby completing the production of a cell string. According to the cell string welding method provided in another aspect of the present disclosure, by applying the photosensitive adhesive to the surfaces of the cells and then stacking the solder ribbons with the cells, the production of a cell string by welding is achieved with light irradiation.

### Brief Description of the Drawings

FIG. 1 is a top view of a cell string welding machine according to an optional embodiment of the present disclosure.
FIG. 2 is a side view of FIG. 1.
FIG. 3 is a perspective view of a cell string welding machine according to an optional embodiment of the present disclosure.
FIG. 4 is a side cross-sectional view of FIG. 3.

In the figures, reference numerals in the accompanying drawings are as follows:
1. Conveying portion; 2. solder ribbon group; 3. Positioning and compressing portion; 4. First irradiation sub-portion; 5. Second irradiation sub-portion; 6. Conveying belt; 7. Conveying bottom plate; 8. Bearing plate; 9. Abutting device; 10. Second through hole; 11. Row of pressing pins.

### Detailed Description of Embodiments

In order to make the objectives, features and advantages of the present disclosure more clear and easily understood, the present disclosure will be further described in detail below with reference to the accompanying drawings and specific implementations.

The present disclosure discloses a cell string welding machine for welding cells without main grids.

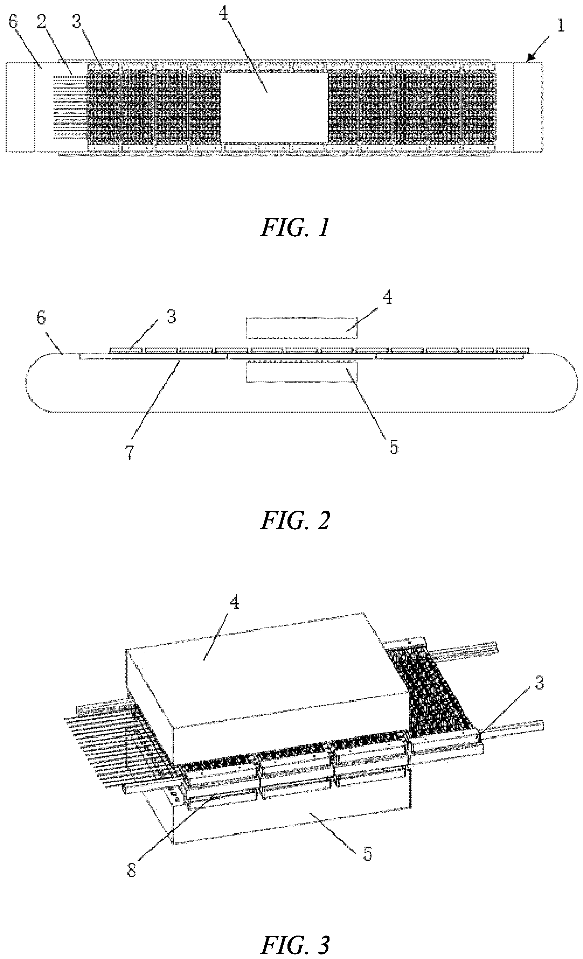

As shown in FIGS. 1, 2 and 3, a first aspect of the present disclosure provides a cell string welding machine. The cell string welding machine includes a adhesive application portion, a cell feeding portion, a solder ribbon feeding portion, a conveying portion 1, and an irradiation portion, wherein the adhesive application portion is configured for applying photosensitive adhesive dots between preset auxiliary grid lines of cells, so as to form at least one row of adhesive dots perpendicular to a length direction of the auxiliary grid lines of the cells on surfaces of the cells; the cell feeding portion is configured for carrying the cells having the row of adhesive dots applied thereon to a material receiving station of the conveying portion 1; the solder ribbon feeding portion is configured for providing a solder ribbon group 2 to a material receiving station of the conveying portion 1; the cell feeding portion and the solder ribbon feeding portion stack the solder ribbon group 2 and the cells on the material receiving station of the conveying portion 1 according to a preset rule, such that solder ribbons of the solder ribbon group 2 are placed to have a one-to-one correspondence with the row of adhesive dots on the cells; the conveying portion 1 conveys the stacked solder ribbon group 2 and the cells to the irradiation portion at a welding station; and the irradiation portion is configured for irradiating the row of adhesive dots, so as to fix the solder ribbon group 2 to the cells.

The row of adhesive dots is formed on the surfaces of the cells by means of the arrangement of the adhesive application portion, the feeding and stacking of the solder ribbon group 2 and the cells are achieved by means of the cell feeding portion and the solder ribbon feeding portion, the conveying of the cells and the solder ribbon group 2 is achieved by means of the conveying portion 1, and solder ribbons are fixed to the row of adhesive dots of the cells by means of the irradiation portion, thereby completing the production of a cell string.

In an implementation, the adhesive application portion can use a spray head to directly spray the photosensitive adhesive dots between the preset auxiliary grid lines of the cells, or apply the photosensitive adhesive dots by a dispensing method using a spray head. Of course, the photosensitive adhesive dots can also be applied by a silk-screen printing method.

During the application, the photosensitive adhesive dots can be applied between adjacent auxiliary grid lines. Alternatively, a photosensitive adhesive dot can be applied with a spacing of two auxiliary grid lines, or the photosensitive adhesive dot can be applied with a spacing of more auxiliary grid lines adjusted as required. The photosensitive adhesive dots are arranged in a row in a direction perpendicular to the auxiliary grid lines of the cells, and a plurality of groups of parallel rows of adhesive dots can be applied to a cell.

The cell feeding portion includes a manipulator, a driving end of the manipulator is mounted with a suction cup for sucking a cell, and the manipulator sucks and place the cell by driving the suction cup.

The solder ribbon feeding portion includes a solder ribbon feeding and moving device, and a solder ribbon grasper for grasping the solder ribbon group 2. The solder ribbon moving device is configured for driving the solder ribbon grasper to grasp and place solder ribbons on the cell, such that the solder ribbons of the solder ribbon groups 2 are placed to have a one-to-one correspondence with the row of adhesive dots. In order to prevent the adhesive dots from adhering to the conveying portion 1 when the cells are placed on the conveying portion 1, the thickness of the adhesive dots should be less than the diameter of each of the solder ribbons of the solder ribbon group 2.

The conveying portion 1 conveys the stacked solder ribbons 2 and cells to the irradiation portion, which irradiates the row of adhesive dots of the cells to cure the adhesive dots such that the solder ribbons and the cells are bonded together to form a cell string.

In an implementation, if electrodes of a cell are respectively on two surfaces of the cell, a first solder ribbon group needs to be placed first when the cells and the solder ribbons are stacked, and a first cell is then placed on a rear half of the first solder ribbon group such that the row of adhesive dots on a back surface of the first cell has a one-to-one correspondence with the solder ribbons; then, a second solder ribbon group is placed such that a front half of the second solder ribbon group is placed on a front surface of the first cell and has a one-to-one correspondence with the row of adhesive dots on the front surface of the first cell, and a second cell is then placed on a rear half of the second solder ribbon group such that the row of adhesive dots on a back surface of the second cell has a one-to-one correspondence with the second solder ribbon group; the process is repeated in this way until a tail cell is placed, and a tail solder ribbon group is then placed on the tail cell such that a front half of the tail solder ribbon group is placed to have a one-to-one correspondence with the row of adhesive dots on the tail cell.

If the cells are interdigitated back contact cells, that is, positive and negative electrodes of the solder ribbons are all on the back surfaces of the cells, the row of adhesive dots formed by applying the adhesive dots between negative auxiliary grid lines on the back surfaces of the cells is a row of auxiliary electrode adhesive dots, and the row of adhesive dots applied between positive auxiliary grid lines of the cells is row of positive electrode adhesive dots. During the arrangement, it is required to first arrange the cells on the conveying portion 1 with the back surfaces facing upwards, a solder ribbon group is then placed on the cells in such a way that one section of the solder ribbon group is connected to the row of auxiliary electrode adhesive dots of a cell adjacent thereto, and the other section of the solder ribbon group is connected to the row of positive electrode adhesive dots of another cell adjacent thereto. Of course, it is also possible to arrange the solder ribbons on the conveying portion 1 before placing the cells on the solder ribbons with the back surfaces facing downwards, such that a section of the solder ribbon group is connected to the row of negative electrode adhesive dots of a cell adjacent thereto, and the other section of the solder ribbon group is connected to the row of positive electrode adhesive dots of another cell adjacent thereto.

Then, the stacked solder ribbon groups 2 and cells are conveyed to the irradiation portion by the conveying portion 1, the irradiation portion is arranged laterally to a conveying direction of the conveying portion 1, and the irradiation portion irradiates the cells conveyed by the conveying portion 1 such that the row of adhesive dots on the cells are cured by means of irradiation to connect the solder ribbon group 2 and the cells together so as to form a cell string.

In an implementation, the photosensitive adhesive is an UV-curable adhesive, and the irradiation light from the irradiation portion is ultraviolet light. The arrangement of the irradiation portion allows the cells and the solder ribbon group are connected into a string at a low temperature, resulting in reduced energy losses and preventing damages to the cells caused by a high temperature.

In an implementation, in order to better attach the solder ribbons to the cells and to avoid the displacements of the solder ribbons relative to the cells during conveyance, the cell string welding machine further includes a positioning and compressing portion 3. The positioning and compressing portion 3 is configured for compressing the stacked solder ribbons 2 and cells. Also, in order to prevent shading by the positioning and compressing portion 3, the positioning and compressing portion 3 have compressing positions staggered with the positions of the photosensitive adhesive dots.

In an implementation, the positioning and compressing portion 3 is reusable tooling, the positioning and compressing portion 3 is arranged at a first section of the conveying portion 1, and the cell feeding portion may further include a positioning and compressing gripper for gripping both the cells and the positioning and compressing portion 3, so as to achieve the feeding for the positioning and compressing portions 3. The positioning and compressing portion 3 is moved by means of the conveyance by the conveying portion 1 to the irradiation portion synchronously with the solder ribbon group 2 and the cells.

The positioning and pressing of the solder ribbons and the cells that are stacked are achieved by means of the positioning and compressing portion, so as to prevent the offset of the solder ribbons during conveyance.

In an implementation, the conveying portion 1 includes a conveying carrier portion and a conveying drive portion, wherein a driving end of the conveying drive portion is connected to the conveying carrier portion, the conveying drive portion is configured for driving the conveying carrier portion to convey the solder ribbon group 2 and the cells, and the conveying carrier portion is made of a light-transmitting material.

Specifically, the light-transmitting material of the conveying carrier portion is permeable to at least ultraviolet light. The conveying carrier portion may be of glass or an acrylic material.

The solder ribbon group 2 and the cells are carried by the conveying carrier portion, the conveying drive portion drives the conveying carrier portion to achieve conveying, and the row of adhesive dots on a side of each of the cells that faces the carrier portion is irradiated by means of the light-transmitting configuration of the carrier portion.

In an implementation, the irradiation portion includes at least one of a first irradiation sub-portion 4 and a second irradiation sub-portion 5, wherein the first irradiation sub-portion 4 is arranged above a conveying surface of the conveying carrier portion at the welding station, and the first irradiation sub-portion 4 is configured for irradiating the row of adhesive dots on front surfaces of the cells; and the second irradiation sub-portion 5 is arranged below the conveying surface of the conveying carrier portion at the welding station, and the second irradiation sub-portion 5 is configured for irradiating the row of adhesive dots on back surfaces of the cells.

When it is required to irradiate both surfaces of each of the cells, the irradiation portion includes the first irradiation sub-portion 4 and the second irradiation sub-portion 5, and when it is required to irradiate an upper or lower surface of the cell, only the first irradiation sub-portion 4 or only the second irradiation sub-portion 5 may be used as needed.

The first irradiation sub-portion 4 and the second irradiation sub-portion 5 are both ultraviolet lamps.

The row of adhesive dots on the cells is irradiated by means of the arrangement of the first irradiation sub-portion 4, and the row of adhesive dots on the back surfaces of the cells is irradiated by means of the arrangement of the second irradiation sub-portion 5.

In an implementation, the conveying carrier portion includes a conveying belt 6 and a conveying bottom plate 7, and the conveying drive portion includes a first drive device and a set of support rollers; a driving end of the first drive device is connected to the set of support rollers, the first drive device is configured for driving the set of support rollers to rotate, the conveying belt 6 is sleeved on the set of support rollers, and the conveying belt 6 rotates with the set of support rollers; the conveying bottom plate 7 is arranged below the conveying surface of the conveying belt 6, and the conveying bottom plate 7 is configured for supporting the conveying belt 6; and the conveying belt 6 is a light-transmitting belt, and the conveying bottom plate 7 is a light-transmitting plate.

In an implementation, the conveying belt 6 is a Teflon belt which is permeable to ultraviolet light.

The cells and the solder ribbon group 2 are received by means of the arrangement of the conveying belt 6, the conveying belt 6 is supported during the conveyance by means of the arrangement of the conveying bottom plate 7, the conveying belt 6 is supported and transported by means of the arrangement of the first drive device and the set of support rollers, and the transmission of the irradiation light from the irradiation portion is achieved by configuring the conveying belt 6 as the light-transmitting belt and the conveying bottom plate 7 as the light-transmitting plate.

In an implementation, first through holes are provided in the conveying belt 6, negative-pressure suction holes are provided in the conveying bottom plate 7, and the negative-pressure suction holes in the conveying bottom plate 7 suck the cells to the conveying belt 6 by means of the first through holes in the conveying belt 6.

By providing the first through holes in the conveying belt 6, the negative-pressure suction holes in a suction bottom plate suck the cells to be closely attached to the conveying belt 6.

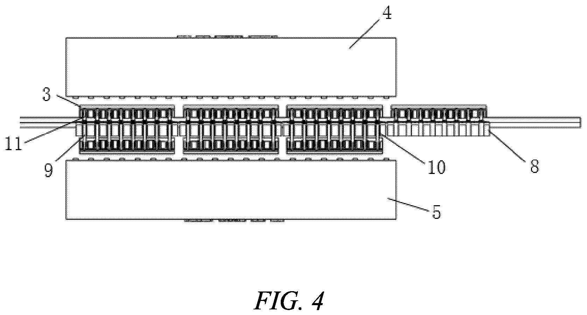

In an implementation, as shown in FIGS. 3 and 4, the conveying carrier portion includes a bearing plate 8, and the conveying drive portion includes a second drive device; a driving end of the second drive device is connected to the bearing plate 8, and the second drive device is configured for driving the bearing plate 8 to be moved from the material receiving station to the welding station; the bearing plate 8 is configured for carrying the solder ribbon group 2 and the cells; and the bearing plate 8 is a light-transmitting plate.

The solder ribbon group 2 and the cells are carried by the arrangement of the bearing plate 8, the carrier plate is moved by the provision of the drive portion and thus the solder ribbon group 2 and the cells are conveyed, and the transmission of the irradiation light from the irradiation portion is achieved by configuring the carrier portion as the light-transmitting plate.

In an implementation, as shown in FIG. 4, the conveying portion 1 further includes abutting devices 9, the bearing plate 8 is provided with second through holes 10 for the abutting devices 9 to pass through; and the abutting devices 9 are configured for abutting the solder ribbon group 2 conveyed by the bearing plate 8 and located below the cells against the back surfaces of the cells.

In an implementation, the abutting devices 9 are elastic ejector pins mounted on a lifting device, the lifting device drives the elastic ejector pins to descend when no operation is needed, the lifting device drive the elastic ejector pins to rise when irradiation for welding is required, and the ejector pins elastically compress the solder ribbons against the back surfaces of the cells, thereby ensuring that the solder ribbons are closely attached to the cells during the irradiation for welding, and improving the welding quality of the cell string.

By providing the abutting devices 9, the solder ribbon group 2 below the cells can be closely attached to the cells when being exposed to the irradiation of the irradiation portion, thereby improving a welding effect.

In an implementation, the positioning and compressing portion 3 includes a mounting frame and rows of pressing pins 11 mounted on the mounting frame, the rows of pressing pins 11 being arranged to correspond to the solder ribbon group 2, and each row of pressing pins 11 being used to press a solder ribbon.

Each row of pressing pins 11 contains at least two elastic pressing pins.

The solder ribbons are better positioned by providing the rows of pressing pins 11.

Another aspect of the present disclosure provides a cell string welding method, including:
applying photosensitive adhesive dots between preset auxiliary grid lines of cells, so as to form at least one row of adhesive dots perpendicular to a length direction of the auxiliary grid lines of the cells on surfaces of the cells; providing a solder ribbon group 2, the number of solder ribbons of the solder ribbon group 2 being the same as the number of the rows of adhesive dots; stacking the solder ribbon group 2 and the cells according to a preset rule such that the stacked solder ribbons of the solder ribbon group 2 have a one-to-one correspondence with the rows of adhesive dots on the cells; and irradiating the cells and the solder ribbon group 2 stacked together such that the solder ribbon group 2 and the rows of adhesive dots on the cells are bonded together to form a cell string.

In an implementation, the photosensitive adhesive used in this method is an UV-curable adhesive, and the irradiation light is ultraviolet light. By providing the UV-curable adhesive and the ultraviolet light, the cells and the solder ribbon group are bonded by low-temperature welding to form a cell string, resulting in reduced energy losses and effectively preventing damages to the cells caused by temperature during high-temperature welding. The quality of the cell string produced is effectively improved.

The row of adhesive dots on the cells are stacked with the solder ribbon group 2, and the solder ribbon group 2 and the cells stacked together are irradiated to position and weld the solder ribbon group 2 and the cells together, thus completing the production of a cell string.

In an implementation, stacking the solder ribbon group 2 and the cells according to a preset rule includes:
stacking an i^{th} cell on a rear half of an i^{th} solder ribbon group 2, and stacking a front half of an (i+1)^{th} solder ribbon group 2 on the i^{th} cell, i being any natural number greater than 0.

In order to ensure a compressing effect, the positioning and compressing portion can be placed on the solder ribbon group and the cells after stacking, so as to compress the solder ribbon group and the cells together. The positioning and compressing portion includes a frame and rows of pressing pins mounted on the frame, the rows of pressing pins being placed to have a one-to-one correspondence with the solder ribbons of the solder ribbon group.

In an implementation, stacking the solder ribbon group 2 and the cells according to a preset rule includes: the cells being interdigitated back contact cells, and because of the cells being the interdigitated back contact cells, the positive and negative electrodes of the cells being all integrated into the back surfaces of the cells, therefore, when the photosensitive adhesive is applied, it being only required to apply a row of positive electrode adhesive dots between the negative grid lines corresponding to the positive electrodes of the back surfaces of the cells, and a row of negative electrode adhesive dots between the negative grid lines corresponding to the negative electrodes of the back surfaces of the cells.

When the solder ribbon group and the interdigitated back contact cells are stacked, the solder ribbon group can be placed first, the cells are then placed, and finally the positioning and compressing portion is placed on the cells to position and compress the solder ribbon group and the cells together; or it is possible to place the cells first, then place the solder ribbon group, and later place the positioning and compressing portion to compress the solder ribbon group and the cells together.

The positioning and compressing portion includes a frame and rows of pressing pins mounted on the frame, the rows of pressing pins being placed to have a one-to-one correspondence with the solder ribbons of the solder ribbon group.

The process of stacking the interdigitated back contact cells and the solder ribbon group includes: connecting a front half of an I^{th} solder ribbon group to a row of positive electrode adhesive dots on a back surface of an (I-1)^{th} cell, connecting a rear half of the I^{th} solder ribbon group to a row of negative electrode adhesive dots on a back surface of an I^{th} cell, and connecting a front half of an (I+1)^{th} solder ribbon group to a row of positive electrode adhesive dots on the back surface of the I^{th} cell, and connecting a rear half of the (I+1)^{th} solder ribbon group to a row of negative electrode adhesive dots on a back surface of an (I+1)^{th} cell, I being any odd number greater than 0; or connecting the front half of the I^{th} solder ribbon group to a row of negative electrode adhesive dots on the back surface of the (I-1)^{th} cell, connecting the rear half of the I^{th} solder ribbon group to a row of positive electrode adhesive dots on the back surface of the I^{th} cell, and connecting the front half of the (I+1)^{th} solder ribbon group to the row of negative electrode adhesive dots on the back surface of the I^{th} cell, and connecting the rear half of the (I+1)^{th} solder ribbon group to the row of positive electrode adhesive dots on the back surface of the (I+1)^{th} cell, I being any odd number greater than 0.

According to the cell string welding machine provided in the present disclosure, the row of adhesive dots is formed on the surfaces of the cells by means of the arrangement of the adhesive application portion, the feeding and stacking of the solder ribbon group 2 and the cells are achieved by means of the cell feeding portion and the solder ribbon feeding portion, the conveying of the cells and the solder ribbon group 2 is achieved by means of the conveying portion 1, and solder ribbons are fixed to the row of adhesive dots of the cells by means of the irradiation portion, thereby completing the production of a cell string. According to the cell string welding method provided in another aspect of the present disclosure, by applying the photosensitive adhesive to the surfaces of the cells and then stacking the solder ribbons with the cells, the production of a cell string by welding is achieved with light irradiation.

The present disclosure has been described in sufficient detail with certain particularities above. Those skilled in the art should understand that the description of the embodiments is only exemplary, and all changes made without departing from the true spirit and scope of the present disclosure should fall within the scope of protection of the present disclosure. The scope of protection of the present disclosure is defined by the claims, rather than by the above description of the embodiments.

## Claims

1. A cell string welding machine, **characterized in that** the cell string welding machine comprises a adhesive application portion, a cell feeding portion, a solder ribbon feeding portion, a conveying portion, and an irradiation portion; wherein
the adhesive application portion is configured for applying photosensitive adhesive dots between preset auxiliary grid lines of cells, so as to form at least one row of adhesive dots perpendicular to a length direction of the auxiliary grid lines of the cells on surfaces of the cells;
the cell feeding portion is configured for carrying the cells having the row of adhesive dots applied thereon to a material receiving station of the conveying portion;
the solder ribbon feeding portion is configured for providing a solder ribbon group to the material receiving station of the conveying portion;
the cell feeding portion and the solder ribbon feeding portion stack the solder ribbon group and the cells on the material receiving station of the conveying portion according to a preset rule, such that solder ribbons of the solder ribbon group are placed to have a one-to-one correspondence with the row of adhesive dots on the cells;
the conveying portion conveys the stacked solder ribbon group and cells to the irradiation portion at a welding station; and
the irradiation portion is configured for irradiating the row of adhesive dots, so as to fix the solder ribbon group to the cells.

2. The cell string welding machine of claim 1, **characterized in that** the cell string welding machine further comprises a positioning and compressing portion, wherein
the positioning and compressing portion is configured for pressing the stacked solder ribbons and cells, and
the positioning and compressing portion has compressing positions staggered with the positions of the photosensitive adhesive dots.

3. The cell string welding machine of claim 1, **characterized in that** the conveying portion comprises a conveying carrier portion and a conveying drive portion, wherein
a driving end of the conveying drive portion is connected to the conveying carrier portion, the conveying drive portion is configured for driving the conveying carrier portion to convey the solder ribbon group and the cells, and
the conveying carrier portion is made of a light-transmitting material.

4. The cell string welding machine of claim 3, **characterized in that** the irradiation portion comprises at least one of a first irradiation sub-portion and a second irradiation sub-portion, wherein
the first irradiation sub-portion is arranged above a conveying surface of the conveying carrier portion at the welding station, and the first irradiation sub-portion is configured for irradiating the row of adhesive dots on front surfaces of the cells; and
the second irradiation sub-portion is arranged below the conveying surface of the conveying carrier portion at the welding station, and the second irradiation sub-portion is configured for irradiating the row of adhesive dots on back surfaces of the cells.

5. The cell string welding machine of claim 3, **characterized in that** the conveying carrier portion comprises a conveying belt and a conveying bottom plate, and the conveying drive portion comprises a first drive device and a set of support rollers;
a driving end of the first drive device is connected to the set of support rollers, the first drive device is configured for driving the set of support rollers to rotate,
the conveying belt is sleeved on the set of support rollers, and the conveying belt rotates with the set of support rollers;
the conveying bottom plate is arranged below the conveying surface of the conveying belt, and the conveying bottom plate is configured for supporting the conveying belt; and
the conveying belt is a light-transmitting belt, and the conveying bottom plate is a light-transmitting plate.

6. The cell string welding machine of claim 5, **characterized in that**
first through holes are provided in the conveying belt, negative-pressure suction holes are provided in the conveying bottom plate, and the negative-pressure suction holes in the conveying bottom plate suck the cells to the conveying belt by means of the first through holes in the conveying belt.

7. The cell string welding machine of claim 3, **characterized in that** the conveying carrier portion comprises a bearing plate, and the conveying drive portion comprises a second drive device;
a driving end of the second drive device is connected to the bearing plate, and the second drive device is configured for driving the bearing plate to be moved from the material receiving station to the welding station;
the bearing plate is configured for carrying the solder ribbon group and the cells; and
the bearing plate is a light-transmitting plate.

8. The cell string welding machine of claim 7, **characterized in that** the conveying portion further comprises abutting devices, the bearing plate is provided with second through holes for the abutting devices to pass through; and
the abutting devices are configured for abutting the solder ribbon group conveyed by the bearing plate and located below the cells against the back surfaces of the cells.

9. The cell string welding machine of claim 2, **characterized in that** the positioning and compressing portion comprises a mounting frame and rows of pressing pins mounted on the frame, wherein
the rows of pressing pins are arranged to have a one-to-one correspondence with the solder ribbons of the solder ribbon group.

10. A cell string welding method, **characterized by** comprising:
applying photosensitive adhesive dots between preset auxiliary grid lines of cells, so as to form at least one row of adhesive dots perpendicular to a length direction of the auxiliary grid lines of the cells on surfaces of the cells;
providing a solder ribbon group, the number of solder ribbons of the solder ribbon group being the same as the number of the rows of adhesive dots;
stacking the solder ribbon group and the cells according to a preset rule such that the stacked solder ribbons of the solder ribbon group have a one-to-one correspondence with the rows of adhesive dots on the cells; and
irradiating the cells and the solder ribbon group stacked together, such that the solder ribbon group and the rows of adhesive dots on the cells are bonded together to form a cell string.

11. The cell string welding method according to claim 10, **characterized in that** stacking the solder ribbon group and the cells according to a preset rule comprises:
stacking an i^{th} cell on a rear half of an i^{th} solder ribbon group, and stacking a front half of an (i+1)^{th} solder ribbon group on the i^{th} cell, i being any natural number greater than 0.

12. The cell string welding method according to claim 10, **characterized in that** stacking the solder ribbon group and the cells according to a preset rule comprises: the cells being interdigitated back contact cells,
connecting a front half of an I^{th} solder ribbon group to a row of positive electrode adhesive dots on a back surface of an (I-1)^{th} cell, connecting a rear half of the I^{th} solder ribbon group to a row of negative electrode adhesive dots on a back surface of an I^{th} cell, and
connecting a front half of an (I+1)^{th} solder ribbon group to a row of positive electrode adhesive dots on the back surface of the I^{th} cell, and connecting a rear half of the (I+1)^{th} solder ribbon group to a row of negative electrode adhesive dots on a back surface of an (I+1)^{th} cell, I being any odd number greater than 0;
or
connecting the front half of the I^{th} solder ribbon group to a row of negative electrode adhesive dots on the back surface of the (I-1)^{th} cell, connecting the rear half of the I^{th} solder ribbon group to a row of positive electrode adhesive dots on the back surface of the I^{th} cell, and
connecting the front half of the (I+1)^{th} solder ribbon group to the row of negative electrode adhesive dots on the back surface of the I^{th} cell, and connecting the rear half of the (I+1)^{th} solder ribbon group to the row of positive electrode adhesive dots on the back surface of the (I+1)^{th} cell, I being any odd number greater than 0.
